# EUROPEAN PATENT SPECIFICATION

(11) **EP 3 401 967 B1**
(45) Date of publication and mention of the grant of the patent: **29.07.2020**
(21) Application number: 16883860.5
(22) Date of filing: 27.12.2016
(51) Int. Cl.: H01L 35/22, B82Y 30/00, H01L 35/26, H01L 35/34, H01L 51/00, H01L 51/30

(54) **THERMOELECTRIC CONVERSION MATERIAL AND THERMOELECTRIC CONVERSION DEVICE**
MATERIAL ZUR THERMOELEKTRISCHEN UMWANDLUNG UND VORRICHTUNG ZUR THERMOELEKTRISCHEN UMWANDLUNG
MATÉRIAU DE CONVERSION THERMOÉLECTRIQUE ET DISPOSITIF DE CONVERSION THERMOÉLECTRIQUE

(30) Priority: 05.01.2016 JP 2016000380
(43) Date of publication of application: 14.11.2018
(73) Proprietor: Sekisui Chemical Co., Ltd., Osaka-shi, Osaka 530-8565 (JP); National University Corporation Nara Institute of Science and Technology, Ikoma-shi, Nara 630-0192 (JP)
(72) Inventor: ISHIMARU, Masatoshi, Osaka 618-0021 (JP); NONOGUCHI, Yoshiyuki, Ikoma-shi Nara 630-0192 (JP); KAWAI, Tsuyoshi, Ikoma-shi Nara 630-0192 (JP)
(74) Representative: Ter Meer Steinmeister & Partner
(86) International application number: PCT/JP2016/088896
(87) International publication number: WO 2017/119361

(56) References cited:
- WO-A1-2014/126211
- WO-A1-2014/157259
- WO-A1-2015/005340
- CHOONGHO YU ET AL: "Light-Weight Flexible Carbon Nanotube Based Organic Composites with Large Thermoelectric Power Factors", ACS NANO, vol. 5, no. 10, 1 January 2011 (2011-01-01), pages 7885-7892, XP055357323, US ISSN: 1936-0851, DOI: 10.1021/nn202868a
- YASUMITSU MIYATA ET AL: "Purity and Defect Characterization of Single-Wall Carbon Nanotubes Using Raman Spectroscopy", JOURNAL OF NANOMATERIALS, vol. 2011, 1 January 2011 (2011-01-01), pages 1-7, XP055603322, US ISSN: 1687-4110, DOI: 10.1155/2011/786763
- MOTOHIRO NAKANO et al.: "Flexible thermoelectric rubber polymer composites based on single-walled carbon nanotubes", Japanese Journal of Applied Physics, vol. 54, no. 4s 18 February 2015 (2015-02-18), pages 04DN03-01-04DN03-4, XP055496813, Retrieved from the Internet: URL:http://dx.doi.org/10.7567/JJAP.54.04DN 03
- MOTOHIRO NAKANO et al.: "Enhanced Thermoelectric Properties of Single-walled Carbon Nanotubes with Ionic Liquid-Derived Polymers", The 49th Fullerenes-Nanotubes- Graphene General Symposium,Koen Yoshishu, 7 September 2015 (2015-09-07), page 122, XP009511776,
- YOSHIYUKI NONOGUCHI et al.: "1T19 Kobunshi Denkaishitsu -Tanso Carbon Nanotube Fukugotai ni Mirareru Zokyo Netsuden Koka [Single-Walled Carbon Nanotube-Polyelectrolyte Composites Exhibiting Superior Thermoelectric Power Factor]", Dai 64 Kai Symposium on Macromolecules Polymer Preprints; 64th SPSJ Symposium on Macromolecules : Sendai, Japan, September 15 - 17, 2015, vol. 64, no. 2, 15 September 2015 (2015-09-15), pages 1-2, XP009511778, JP
- YOSHIYUKI NONOGUCHI et al.: "Air-tolerant Fabrication and Enhanced Thermoelectric Performance of n-Type Single-walled Carbon Nanotubes Encapsulating 1,1'-Bis (diphenylphosphino)ferrocene", CHEMISTRY AN ASIAN JOURNAL, vol. 11, no. 17, 1 January 2016 (2016-01-01), pages 2423-2427, XP055558645, DOI: 10.1002/asia.201600810

## Description

### TECHNICAL FIELD

The present invention relates to a thermoelectric conversion material containing a carbon nanotube. Further, the present invention relates to a thermoelectric conversion device using the thermoelectric conversion material described above.

### BACKGROUND ART

In recent years, approaches to energy problems are becoming active, and expectations for a recovery technique of heat energy are becoming high. Heat can be recovered from various scenes of body temperature, solar heat, engine and industrial waste heat, and the like, and is the most common energy source. In addition, in order to realize a low-carbon society with high energy efficiency, the necessity for a recovery technique of heat energy has been increased.

As the recovery technique of heat energy, a thermoelectric conversion device on the basis of Seebeck effect (or Peltier effect) has already been utilized in various scenes of temperature difference power generation, a heat sensor, cooling, and the like. The thermoelectric conversion device has, for example, a module structure in which a large number of the thermocouples being a combination of a p-type semiconductor and an n-type semiconductor are connected in series. Such a thermoelectric conversion device has many advantages that there is no noise and no vibration because there is no moving part, there is no scale effect, power generation can be performed even with small temperature difference, and incorporation into various equipment and environments can be performed.

One example of the thermoelectric conversion device as described above is disclosed in the following Patent Document 1. The thermoelectric conversion device described in Patent Document 1 contains a stress relaxation layer, a flexible substrate, and a thermoelectric conversion element, which are laminated in this order. The thermoelectric conversion element has a first electrode, a thermoelectric conversion layer containing an organic material, and a second electrode, which are laminated in this order. The stress relaxation layer adjusts the warpage of the flexible substrate. In the thermoelectric conversion layer, for example, as the organic material, a conductive polymer and a conductive nanomaterial (in particular, carbon nanotube (CNT)) may be used in combination.

In addition, in Patent Document 1, there is a description that in a production process of a thermoelectric conversion material, a composition of a thermoelectric conversion material is added into a dispersion medium to obtain a dispersion liquid in which the composition had been dispersed in the dispersion medium. WO 2014/157259 A1 (Fujifilm Corp.) 2 October 2014 (2014-10-02) & US 2016/0013392 (2016-01-14) discloses a method for manufacturing a thermoelectric conversion element, which involves preparing a dispersoid for thermoelectric conversion layers which uses nano electroconductivity material. CHOONGHO YU ET AL: "Light-Weight Flexible Carbon Nanotube Based Organic Composites with Large Thermoelectric Power Factors", ACS NANO, vol. 5, no. 10, 1 January 2011 (2011-01-01), pages 7885-7892, XP055357323, US ISSN: 1936-0851 is a paper which reports carbon nanotube based organic composites that provide great opportunities for achieving easy-to-manufacture, light-weight, flexible, inexpensive, and nontoxic energy recovery and solid-state cooling.

### Related Art Document

### Patent Document

Patent Document 1: JP 2015-092557 A

### SUMMARY OF THE INVENTION

### PROBLEMS TO BE SOLVED BY THE INVENTION

It is considered that there is a tendency that in a dispersion liquid of a composition of a thermoelectric conversion material, the more uniformly the composition is dispersed, the higher the conductivity of the thermoelectric conversion material to be obtained is. However, as a result of the study by the present inventors, it has been found that if the dispersibility of the composition is increased in order to increase the conductivity, the Seebeck coefficient may be largely lowered in some cases. As described above, in the conventional thermoelectric conversion material, it is difficult to achieve both of the high conductivity and the high Seebeck coefficient.

An object of the present invention is to provide a thermoelectric conversion material capable of increasing the conductivity and increasing the Seebeck coefficient. In addition, an object of the present invention is also to provide a thermoelectric conversion device using the thermoelectric conversion material described above.

### MEANS FOR SOLVING THE PROBLEMS

According to a broad aspect of the present invention, a thermoelectric conversion material that contains a carbon nanotube, and has a G/D ratio of 25 or more as determined by Raman spectroscopic measurement, an electrical conductivity of 500 S/cm or more, and a Seebeck coefficient of 50 µV/K or more, wherein the G/D ratio relates to the ratio of the peak area of the G band to the peak area of the D band, and wherein the G band is a band located in the vicinity of 1350 cm⁻¹ and the D band is a band located in the vicinity of 1589 cm⁻¹, is provided.

The thermoelectric conversion material according to the present invention is preferably a thermoelectric conversion material in a sheet shape.

In a certain aspect of the thermoelectric conversion material according to the present invention, the content of the carbon nanotube is 70% by weight or more.

According to a broad aspect of the present invention, a thermoelectric conversion device that contains the above-described thermoelectric conversion material, a first electrode disposed on a surface of the thermoelectric conversion material, and a second electrode disposed on a surface of the thermoelectric conversion material at a position distant from the first electrode is provided.

### EFFECT OF THE INVENTION

The thermoelectric conversion material according to the present invention contains a carbon nanotube, and has a G/D ratio of 25 or more as determined by Raman spectroscopic measurement, an electrical conductivity of 500 S/cm or more, and a Seebeck coefficient of 50 µV/K or more, therefore, can increase the conductivity, and further increase the Seebeck coefficient.

### BRIEF DESCRIPTION OF DRAWINGS

[Fig. 1] Fig. 1 is a sectional view of a thermoelectric conversion device according to the first embodiment of the present invention.
[Fig. 2] Fig. 2 is a drawing showing the electrical conductivities of the thermoelectric conversion materials of Example 1 and Comparative Example 1.
[Fig. 3] Fig. 3 is a drawing showing the Seebeck coefficients of the thermoelectric conversion materials of Example 1 and Comparative Example 1.
[Fig. 4] Fig. 4 is a drawing showing the power factors of the thermoelectric conversion materials of Example 1 and Comparative Example 1.
[Fig. 5] Fig. 5 is a drawing showing the electrical conductivities of the thermoelectric conversion materials of Example 2 and Comparative Example 2.
[Fig. 6] Fig. 6 is a drawing showing the Seebeck coefficients of the thermoelectric conversion materials of Example 2 and Comparative Example 2.
[Fig. 7] Fig. 7 is a drawing showing the power factors of the thermoelectric conversion materials of Example 2 and Comparative Example 2.

### MODE(S) FOR CARRYING OUT THE INVENTION

Hereinafter, the present invention will be described in detail.

The thermoelectric conversion material according to the present invention contains a carbon nanotube. The G/D ratio of the thermoelectric conversion material according to the present invention as determined by Raman spectroscopic measurement is 25 or more. The Raman spectroscopic measurement in the present invention is the Raman spectroscopic measurement using light having a wavelength of 532 nm.

The electrical conductivity of the thermoelectric conversion material according to the present invention is 500 S/cm or more. The Seebeck coefficient of the thermoelectric conversion material according to the present invention is 50 µV/K or more.

It is considered that there is a tendency that in a dispersion liquid of a composition of a thermoelectric conversion material, the more uniformly the composition is dispersed, the higher the conductivity of the thermoelectric conversion material to be obtained is. However, as a result of the study by the present inventors, it has been found that if the dispersibility of the composition is increased in order to increase the conductivity, the Seebeck coefficient may be largely lowered in some cases. As described above, in the conventional thermoelectric conversion material, it is difficult to achieve both of the high conductivity and the high Seebeck coefficient.

Therefore, the present inventors have found that when the G/D ratio of the thermoelectric conversion material is high, the decrease of the Seebeck coefficient is suppressed, and further the conductivity of the thermoelectric conversion material becomes high.

In the present invention, the G/D ratio of the thermoelectric conversion material is 25 or more, therefore, the conductivity can be increased, and further the Seebeck coefficient can also be increased.

From the viewpoint of further increasing the conductivity and further Seebeck coefficient of the thermoelectric conversion material, the G/D ratio is more preferably 30 or more, and furthermore preferably 40 or more.

The above-described thermoelectric conversion material is preferably in a sheet shape. The thermoelectric conversion material in a sheet shape may be folded and used. The above-described thermoelectric conversion material may also be in the form of a nonwoven fabric.

From the viewpoint of effectively increasing the conductivity of the thermoelectric conversion material, the content of the carbon nanotube is preferably 70% by weight or more, more preferably 80% by weight or more, and furthermore preferably 90% by weight or more, and is preferably 100% by weight or less.

From the viewpoint of increasing the thermal electromotive force of the thermoelectric conversion material, the carbon nanotube is preferably a single-wall carbon nanotube (SWCNT).

The thermoelectric conversion device according to the present invention contains the thermoelectric conversion material, a first electrode disposed on a surface of the thermoelectric conversion material, and a second electrode disposed on a surface of the thermoelectric conversion material at a position distant from the first electrode.

In the thermoelectric conversion device according to the present invention, since the constitution described above is provided, the conductivity can be increased, and further the Seebeck coefficient can also be increased.

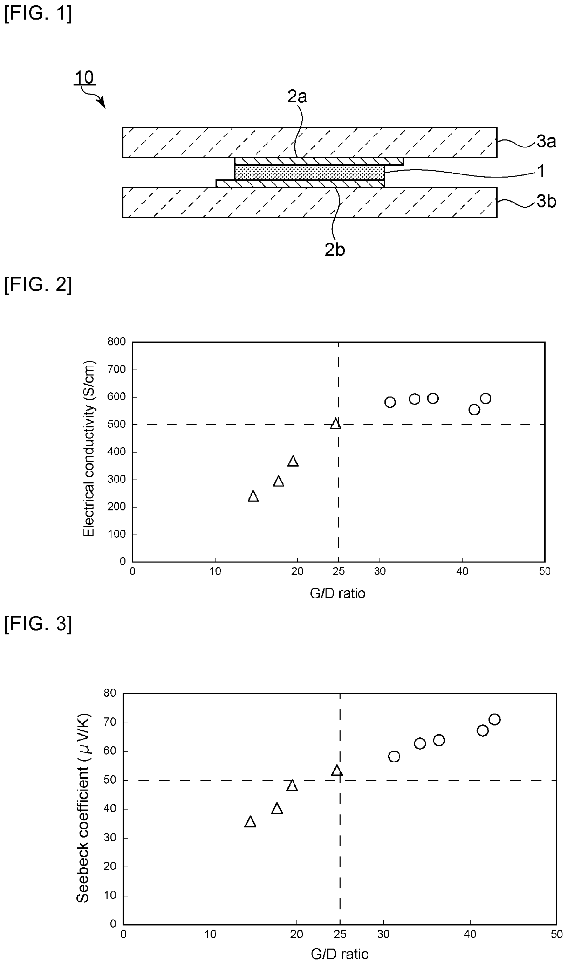

Fig. 1 is a sectional view of a thermoelectric conversion device according to the first embodiment of the present invention.

Note that the drawing referred in the embodiments is schematically described, the ratio of the dimensions, and the like of an object drawn in the drawing may be different from the ratio of the dimensions, and the like of the actual object. The specific ratio of the dimensions, and the like of an object should be determined by taking into consideration the following description.

A thermoelectric conversion device 10 shown in Fig. 1 contains a thermoelectric conversion material 1 in a sheet shape, a first electrode 2a disposed on one side in the thickness direction of the thermoelectric conversion material 1, and a second electrode 2b disposed on the other side opposite to the one side in the thickness direction of the thermoelectric conversion material 1. The second electrode 2b is separated from the first electrode 2a.

One thermoelectric conversion element is constituted of one first electrode 2a, one thermoelectric conversion material 1, and one second electrode 2b.

On the side opposite to the side of the thermoelectric conversion material 1 of the first electrode 2a, a first substrate 3a is provided. On the side opposite to the side of the thermoelectric conversion material 1 of the second electrode 2b, a second substrate 3b is provided. The material for the first and second substrates 3a and 3b is a resin material such as polyimide, an appropriate ceramic material, or the like.

Note that in the thermoelectric conversion device, multiple thermoelectric conversion materials may be laminated and used. The thermoelectric conversion device may contain multiple thermoelectric conversion elements.

In the thermoelectric conversion device 10 shown in Fig. 1, a first electrode 2a is disposed on one side in the thickness direction of the thermoelectric conversion material 1, and a second electrode 2b is disposed on the other side opposite to the one side in the thickness direction of the thermoelectric conversion material 1. Note that the disposition of the first electrode 2a and the second electrode 2b is not limited to the disposition described above, and can be appropriately changed.

Hereinafter, the present invention will be described in more detail on the basis of specific examples.

### (Example 1)

Preparation of thermoelectric conversion material:
In 100 mL of o-dichlorobenzene, 25 mg of SWCNT was placed, and the resultant mixture was stirred using a magnetic stirrer. After that, using a high-pressure type homogenizer, dispersion treatment was performed at a pressure of 40 MPa, and a SWCNT dispersion liquid was obtained. The obtained SWCNT dispersion liquid was subjected to vacuum filtration using a membrane filter having a pore diameter of 0.2 µm, and a SWCNT deposition was obtained. By drying the obtained SWCNT deposition, a thermoelectric conversion material in a sheet shape was obtained.

By the method described above, multiple thermoelectric conversion materials were obtained. Note that each thermoelectric conversion material was prepared by varying the number of times to repeat the dispersion treatment (the number of repetitive processes) in the range of 3 to 10 times.

Measurement of G/D ratio:
Using laser light with a wavelength of 532 nm, Raman spectroscopic measurement of the thermoelectric conversion material was performed, and the peak area in the G band due to the benzene ring in the Raman spectrum was determined. The peak area in the D band due to the defects and the like of the benzene ring in the Raman spectrum was determined. Note that the G band is a band located in the vicinity of 1350 cm⁻¹, and the D band is a band located in the vicinity of 1589 cm⁻¹. The G/D ratio was determined from the ratio of the peak area in the G band to the peak area in the D band.

By the method described above, multiple thermoelectric conversion materials having a G/D ratio of 25 or more and 45 or less were prepared.

### (Example 2)

Preparation of thermoelectric conversion material:
In 100 mL of o-dichlorobenzene, 25 mg of SWCNT was placed, and the resultant mixture was stirred using a magnetic stirrer. After that, dispersion treatment was performed with a centrifugal disc mixer manufactured by SINTOKOGIO, LTD., and a SWCNT dispersion liquid was obtained. The obtained SWCNT dispersion liquid was subjected to vacuum filtration using a membrane filter having a pore diameter of 0.2 µm, and a SWCNT deposition was obtained. By drying the obtained SWCNT deposition, a thermoelectric conversion material in a sheet shape was obtained.

By the method described above, multiple thermoelectric conversion materials were obtained. Note that each thermoelectric conversion material was prepared by varying the number of times to repeat the dispersion treatment (the number of repetitive processes) in the range of 1 to 5 times.

Measurement of G/D ratio:
Using laser light with a wavelength of 532 nm, Raman spectroscopic measurement of the thermoelectric conversion material was performed, and the peak area in the G band due to the benzene ring in the Raman spectrum was determined. The peak area in the D band due to the defects and the like of the benzene ring in the Raman spectrum was determined. Note that the G band is a band located in the vicinity of 1350 cm⁻¹, and the D band is a band located in the vicinity of 1589 cm⁻¹. The G/D ratio was determined from the ratio of the peak area in the G band to the peak area in the D band.

By the method described above, multiple thermoelectric conversion materials having a G/D ratio of 26 or more and 48 or less were prepared.

### (Comparative Example 1)

Multiple thermoelectric conversion materials were prepared in the similar manner as in Example 1 except that the range of the number of repetitive processes of the dispersion treatment in the process of obtaining a SWCNT dispersion liquid was changed to the range of 20 to 50 times. In Comparative Example 1, multiple thermoelectric conversion materials having a G/D ratio of less than 25 were prepared.

### (Comparative Example 2)

Multiple thermoelectric conversion materials were prepared in the similar manner as in Example 2 except that the range of the number of repetitive processes of the dispersion treatment in the process of obtaining a SWCNT dispersion liquid was changed to the range of 7 to 9 times. In Comparative Example 2, multiple thermoelectric conversion materials having a G/D ratio of less than 25 were prepared.

Electrical conductivities, Seebeck coefficients, and power factors of the thermoelectric conversion materials of Examples 1 and 2 and Comparative Examples 1 and 2 were measured.

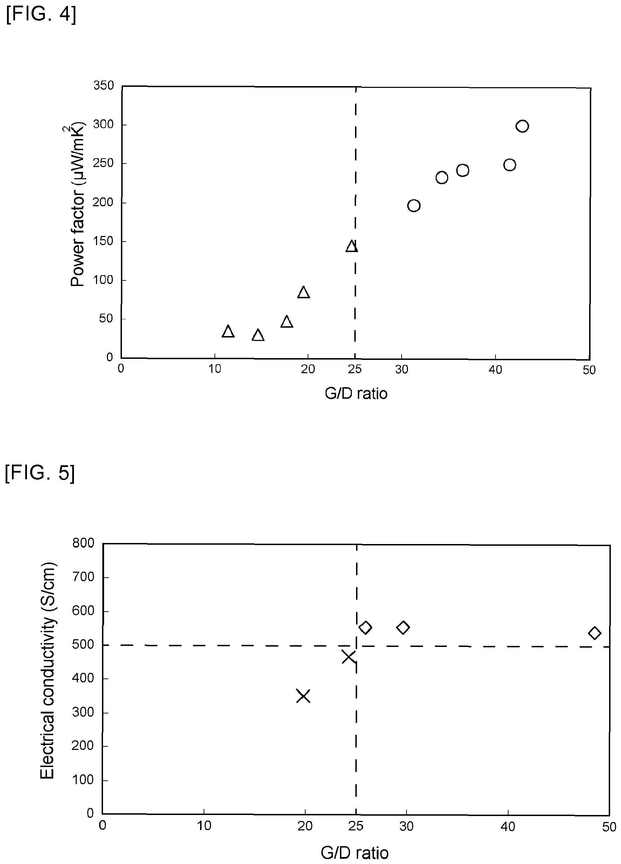

Fig. 2 is a drawing showing the electrical conductivities of the thermoelectric conversion materials of Example 1 and Comparative Example 1. Fig. 3 is a drawing showing the Seebeck coefficients of the thermoelectric conversion materials of Example 1 and Comparative Example 1. Fig. 4 is a drawing showing the power factors of the thermoelectric conversion materials of Example 1 and Comparative Example 1. In Figs. 2 to 4, the circular plots show the results of Example 1, and the triangular plots show the results of Comparative Example 1.

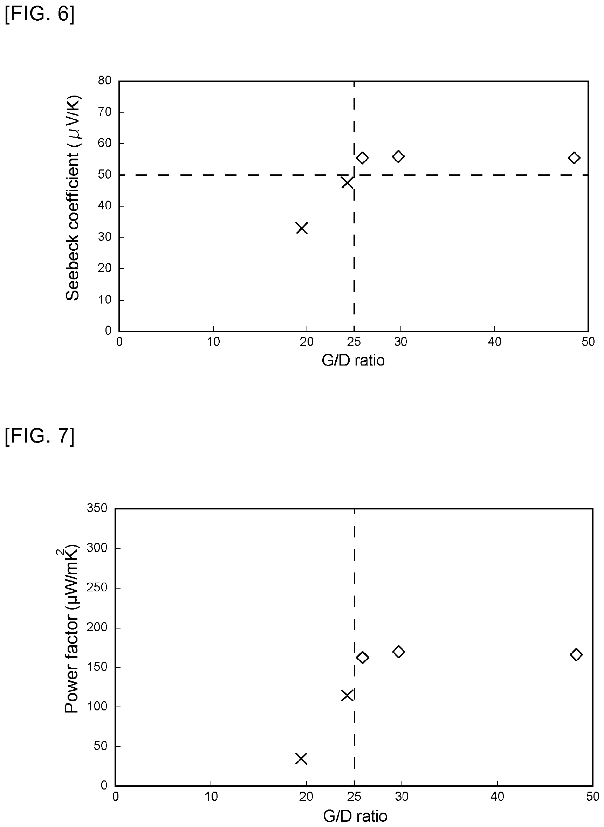

Fig. 5 is a drawing showing the electrical conductivities of the thermoelectric conversion materials of Example 2 and Comparative Example 2. Fig. 6 is a drawing showing the Seebeck coefficients of the thermoelectric conversion materials of Example 2 and Comparative Example 2. Fig. 7 is a drawing showing the power factors of the thermoelectric conversion materials of Example 2 and Comparative Example 2. In Figs. 5 to 7, the square plots show the results of Example 2, and the X-shaped plots show the results of Comparative Example 2.

As shown in Figs. 2 and 3, in Example 1, the conductivity can be more increased and further the Seebeck coefficient can also be more increased as compared with Comparative Example 1. As shown in Figs. 5 and 6, in Example 2, the conductivity can be more increased and further the Seebeck coefficient can also be more increased as compared with Comparative Example 2. As shown in Fig. 4, the power factor of Example 1 is 150 µW/mK² or more, and is higher than the power factor of Comparative Example 1. As shown in Fig. 7, the power factor of Example 2 is 150 µW/mK² or more, and is higher than the power factor of Comparative Example 2.

### EXPLANATION OF SYMBOLS

1: Thermoelectric conversion material
2a, and 2b: First, and second electrodes
3a, and 3b: First, and second substrates
10: Thermoelectric conversion device

## Claims

1. A thermoelectric conversion material, comprising
a carbon nanotube, and having
a G/D ratio of 25 or more as determined by Raman spectroscopic measurement,
an electrical conductivity of 500 S/cm or more, and
a Seebeck coefficient of 50 µV/K or more, wherein the G/D ratio relates to the ratio of the peak area of the G band to the peak area of the D band, and wherein the G band is a band located in the vicinity of 1350 cm⁻¹ and the D band is a band located in the vicinity of 1589 cm⁻¹.

2. The thermoelectric conversion material according to claim 1, wherein
the thermoelectric conversion material is a thermoelectric conversion material in a sheet shape.

3. The thermoelectric conversion material according to claim 1 or 2, wherein
a content of the carbon nanotube is 70% by weight or more.

4. A thermoelectric conversion device, comprising:
the thermoelectric conversion material according to any one of claims 1 to 3,
a first electrode disposed on a surface of the thermoelectric conversion material, and
a second electrode disposed on a surface of the thermoelectric conversion material at a position distant from the first electrode.

## Patentansprüche

1. Thermoelektrisches Umwandlungsmaterial, umfassend
ein Kohlenstoffnanoröhrchen, und das
ein durch Messung der Raman-Spektroskopie bestimmtes G/D-Verhältnis von wenigstens 25,
eine elektrische Leitfähigkeit von wenigstens 500 S/cm, und
einen Seebeck-Koeffizienten von wenigstens 50 µV/K aufweist,
wobei sich das G/D-Verhältnis auf das Verhältnis der Peakfläche der G-Bande zu der Peakfläche der D-Bande bezieht, und wobei die G-Bande eine Bande ist, die sich in der Nähe von 1350 cm⁻¹ befindet, und die D-Bande eine Bande ist, die sich in der Nähe von 1589 cm⁻¹ befindet.

2. Thermoelektrisches Umwandlungsmaterial nach Anspruch 1, wobei das thermoelektrische Umwandlungsmaterial ein thermoelektrisches Umwandlungsmaterial in einer Blattform ist.

3. Thermoelektrisches Umwandlungsmaterial nach Anspruch 1 oder 2, wobei ein Gehalt des Kohlenstoffnanoröhrchens wenigstens 70 Gew.-% beträgt.

4. Thermoelektrische Umwandlungsvorrichtung, umfassend:
das thermoelektrische Umwandlungsmaterial nach einem der Ansprüche 1 bis 3, eine erste Elektrode, die auf einer Oberfläche des thermoelektrischen Umwandlungsmaterials angeordnet ist, und eine zweite Elektrode, die auf einer Oberfläche des thermoelektrischen Umwandlungsmaterials an einer von der ersten Elektrode entfernten Position angeordnet ist.

## Revendications

1. Matériau de conversion thermoélectrique, comprenant un nanotube de carbone, et ayant un rapport G/D de 25 ou plus tel que déterminé par mesure spectroscopique Raman, une conductivité électrique de 500 S/cm ou plus et un coefficient Seebeck de 50 µV/K ou plus, dans lequel le rapport G/D désigne le rapport de l'aire de crête de la bande G à l'aire de crête de la bande D et dans lequel la bande G est une bande située aux environs de 1 350 cm⁻¹ et où la bande D est une bande située aux environs de 1 589 cm⁻¹.

2. Matériau de conversion thermoélectrique selon la revendication 1, dans lequel le matériau de conversion thermoélectrique est un matériau de conversion thermoélectrique en forme de feuille.

3. Matériau de conversion thermoélectrique selon la revendication 1 ou 2, dans lequel une teneur en nanotubes de carbone est de 70 % en poids ou plus.

4. Dispositif de conversion thermoélectrique, comprenant :
le matériau de conversion thermoélectrique selon l'une quelconque des revendications 1 à 3, une première électrode disposée sur une surface du matériau de conversion thermoélectrique et une seconde électrode disposée sur une surface du matériau de conversion thermoélectrique à une position éloignée de la première électrode.
